Europäisches Patentamt

European Patent Office

Office européen des brevets

(19)

(11) Publication number: **0 149 065**
**A2**

## EUROPEAN PATENT APPLICATION

(21) Application number: 84114209.4

(51) Int. Cl.⁴: **H 02 H 9/02**

(22) Date of filing: 24.11.84

(30) Priority: 04.01.84 US 568156

(43) Date of publication of application:
24.07.85 Bulletin 85/30

(84) Designated Contracting States:
DE FR GB IT NL

(71) Applicant: MOTOROLA, INC.
1303 East Algonquin Road
Schaumburg, Illinois 60196(US)

(72) Inventor: Daniels, Paul Jackson
1512 E. Harmony Avenue
Mesa Arizona 85204(US)

(72) Inventor: Stanley, Michael Edward
3707 E. Dewberry
Mesa Arizona 85206(US)

(74) Representative: Ibbotson, Harold
Motorola Ltd Patent and Licensing Operations - Europe
Jays Close Viables Industrial Estate
Basingstoke Hampshire RG22 4PD(GB)

(54) **A protection clamp circuit for use in a monolithic circuit which inhibits current transients.**

(57) First and second Schottky diodes are formed in a respective first and second isolated epitaxial (epi) regions of a monolithic integrated circuit to inhibit current spikes that may otherwise occur as the monolithic circuit is inserted or removed from a "hot" socket having both an input signal and an operating potential supplied thereto. The monolithic circuit includes a floating resistor formed in a first isolated epi region which is connected between the input of the monolithic circuit to which the input signal is supplied and the base of a transistor. The transistor is formed in a third epi region which is isolated from both the first and second epi regions. The second epi region, which may contain one or more circuit elements, is contacted to the operating potential. The Schottky diodes provide clamping across the base-emitter junctions of two parasitic transistors which form a SCR that can be rendered conductive by the substrate not being grounded. The SCR is inhibited from being turned on by the two Schottky clamping diodes.

FIG. 3

EP 0 149 065 A2

0149065

A PROTECTION CLAMP CIRCUIT FOR USE IN A MONOLITHIC
CIRCUIT WHICH INHIBITS CURRENT TRANSIENTS

Background of the Invention

The present invention relates to protection circuits for use in monolithic integrated circuits. More particularly, the present invention relates to a protection circuit which inhibits turn on of a parasitic silicon controlled rectifier (SCR) which can be formed in the monolithic circuit containing diffused resistors within "floating" epitaxial tubs.

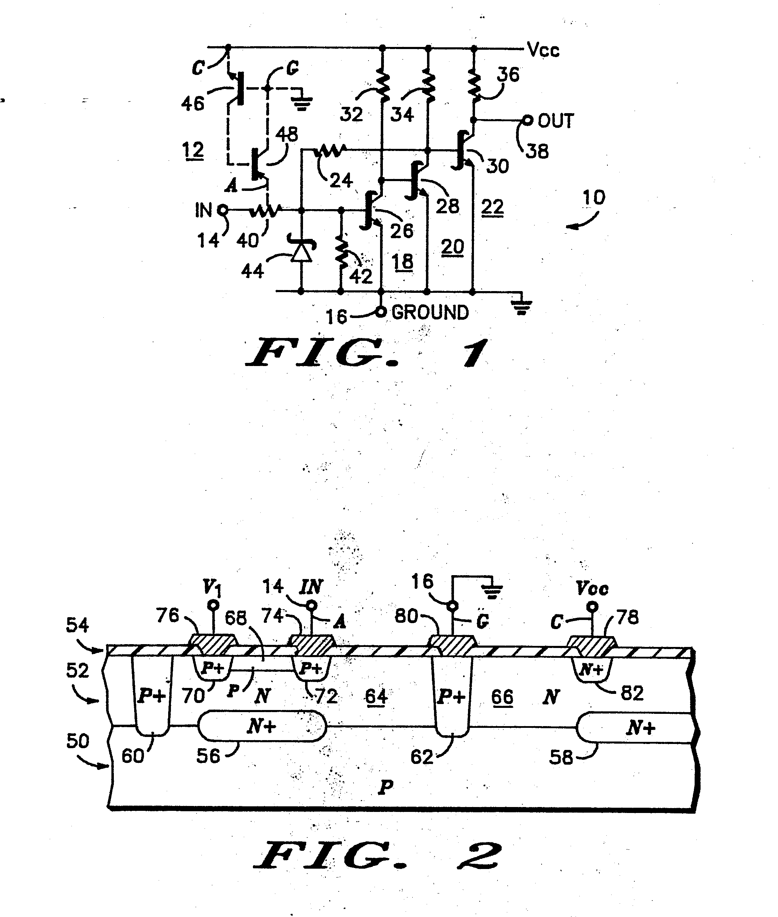

There are integrated circuits (IC's) utilizing diffused resistors that are placed in isolated epitaxial regions, i.e., "floating" epitaxial tubs. For instance, one such IC is the MC1489 Line Receiver that is manufactured by Motorola, Inc. which is schematically illustrated in FIG. 1. The MC1489 comprises an input resistor which is coupled between an external pin of the IC to the base of an internal input transistor thereof. This resistor is diffused into a separate region of the epitaxial layer of the IC which is isolated from other epitaxial regions or tubs by use of diffusion islands as is well known thereby forming an epitaxial tub with no preohmic contact to the epitaxial tub (hereafter referred to as a "floating" epi. island).

Generally, the substrate of the IC is connected to an additional external pin through one of the isolation regions and is intended to be grounded during normal applications of the IC. Similarly, the operating potential for the IC is connected through an external pin to another one of the isolated epitaxial tubs of the IC.

IC manufacturers usually evaluate their IC's after final package assembly to ensure that the IC's meet electrical specifications. Such testing may include inserting and removing the IC from a "hot socket" which has a test input signal and power supply voltages continually supplied thereto. It has been found that if the substrate of the IC, as described above, is not grounded, as can happen while inserting or removing the IC from the hot socket, that a failure mode may occur which can damage or even destroy the IC. This failure mode results from a parasitic SCR that is associated with the floating epitaxial tub in which the resistor is formed. A large current spike, which has been observed, is generated by the parasitic SCR that actually destroys the IC by, among other things, causing evaporation of the metal connecting runs on the IC. Hence, there is a need for a protection circuit to inhibit or at least severely limit the above described current transients.

Summary of the Invention

Accordingly, it is an object of the present invention to provide a Schottky diode protection circuit for use in monolithic circuits.

Another object of the present invention is to provide a monolithic line receiver circuit having a Schottky diode protection circuit.

Still another object of the present invention is to provide circuitry for inhibiting parasitic SCR turn-on in a monolithic circuit.

In accordance with the above and other objects there is provided a monolithic integrated circuit including a substrate and a plurality of isolated epitaxial tubs formed on the substrate, a resistor formed in one of the epitaxial tubs and connected between an input and a second epitaxial tub, and a third isolated epitaxial tub to which contact is made to a supplied operating potential, wherein the integrated circuit has a first Schottky diode formed in said first tub and a second Schottky diode formed in said second tub whereby a parasitic silicon controlled rectifier, otherwise formed between said first and second epitaxial tubs, is clamped to inhibit turn-on of the same if the substrate is not grounded while the input signal and the operating potential are supplied to the monolithic integrated circuit.

Brief Description of the Drawings

FIG. 1 is a schematic diagram of a monolithic circuit illustrating a parasitic SCR circuit formed therein;

FIG. 2 is a cross-sectional view of a portion of the monolithic circuit of FIG. 1;

FIG. 3 is a cross-sectional view of the monolithic circuit of FIG. 1 including the protection circuit of the present invention; and

FIG. 4 is a schematic diagram of the protection circuit in combination with the parasitic SCR of the preferred embodiment.

Detailed Description of the Preferred Embodiment

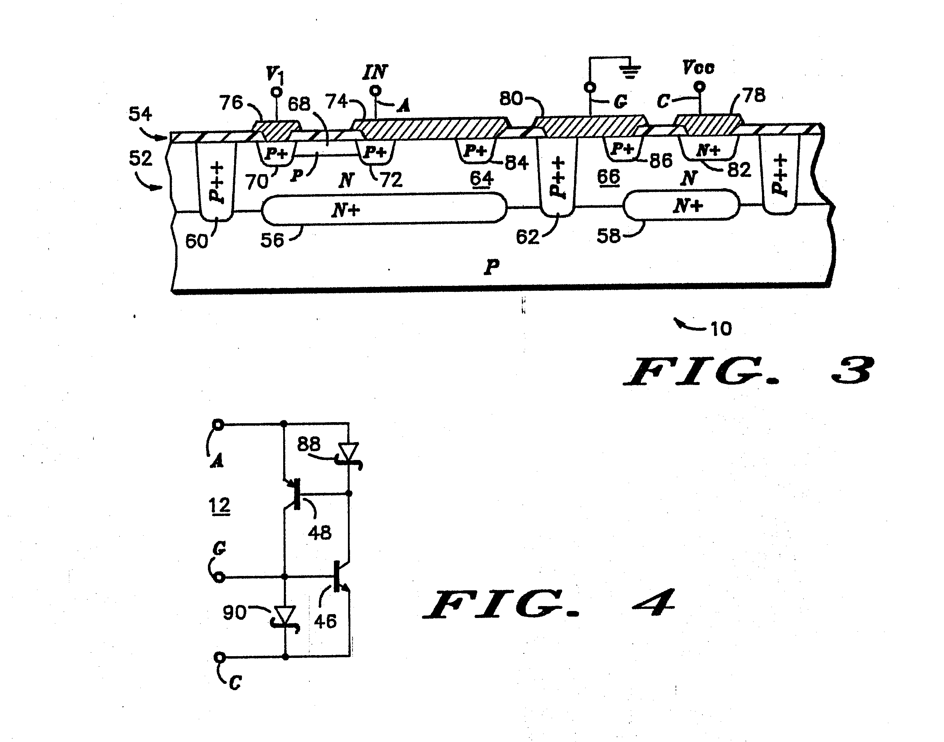

FIGS. 1 and 2 illustrate a typical monolithic integrated circuit 10 which suffers by having a parasitic silicon controlled rectifier (SCR) structure 12 (shown in dashed lines) formed therein which under certain operating conditions can damage or even destroy the integrated circuit. For explanation purposes, circuit 10 may be exemplified by the Motorola, Inc. MC1489 Line Receiver. This Line Receiver is designed to interface data terminal equipment with data communications equipment in comformance with the specifications of EIA standard number RS-232C. In this application the Line Receiver detects an input voltage at external pin 14, the magnitude of which may be between plus and minus 25 volts. In normal application, the substrate of the IC is grounded through external pin 16, as understood, and the IC is supplied an operating potential

$V_{CC}$ of typically 5 volts. Line Receiver 10 comprises three amplifier stages 18, 20, and 22 and has internal feedback from the second intermediate stage 20 to input stage 18 through resistor 24. The three amplifier stages include transistors 26, 28, 30 and resistors 32, 34, and 36 respectively. In response to an applied input voltage at terminal 14, a corresponding output signal is supplied at output terminal 38. Resistor 40 is coupled between input 14 and the base of transistor 26 and is located in a floating epi island in which the epi potential "floats" at most 1 below the most positive potential applied to the resistor: where is a diode voltage drop. Resistor 42 and diode 44 provide biasing of transistor 26 and clamping functions respectively.

As previously mentioned, a serious current transient problem may occur during testing of IC 10 when the substrate is not grounded. To understand the problem that arises a cross-sectional view of IC 10 is illustrated in FIG. 2. As shown, IC 10 is comprised of a substrate 50 which is formed of a first or P-type semiconductor material. An epitaxial or epi layer 52 is then formed onto substrate 50. The epi layer is of a second or N-type semiconductor material. A dielectric layer 54 having selective openings formed therein is disposed onto the upper surface of epi layer 52. Also, during the fabrication process, buried layers 56 and 58 of N+ type semiconductor material may be formed between epi layer 52 and substrate 50. During fabrication P+ isolation regions are selectively formed through the epi layer to isolate different epi regions or tubs from each other as is known. For instance, isolation regions 60 and 62 provide an isolated epi tub 64 and an additional tub 66 within epi layer 52. Resistor 40 is then formed by a P-type region 68 within isolated tub 64 and is disposed between P+ type regions 70 and 72. Conductive metal layers are selectively deposited onto dielectric layer 54 to form circuit connections as required. Input terminal 14 is thereby connected through a metal run which includes metal layer 74 connected to resistor 40 through P+ region 72. Similarly, the distal end of resistor 40 (region 68) is coupled through P+ region 70 and metal layer 76 to the base of transistor 26 as indicated by terminal $V_1$. It is to be understood that transistor 26, as well as transistors 28 and 30 are formed in epi layer 52 in a known and conventional manner. The external power supply voltage is applied through a metal run such as layer 78. Substrate 50 is coupled through appropriate metal runs to external pin 16 which in normal use is grounded. As indicated, P+ isolation region 62 may be contacted to pin 16 through metal layer 80 to connect substrate 50 thereto, or the substrate can be connected through any similar P+ isolation region to provide this connection. Besides being contacted to $V_{CC}$ through N+ contact 82, isolated epi tub 66 may include one or more circuit elements as understood. The manufacturing steps and process for fabricating IC 10 are conventional and are known to those skilled in the art.

As can be seen in FIG. 2, a parasitic SCR 12 is formed by the diffusion layers including resistor 40 (comprised of P regions 68, 70, and 72), N epi region 64, P substrate 50, and N epi region 66. In normal circuit operation, substrate 50 being connected to ground, no mechanism is provided which can turn this parasitic SCR on. Thus, with substrate 50 grounded, parasitic transistor 46 (FIG. 1) of SCR 12 is maintained in an off state. Therefore, neither transistor 46 nor transistor 48 affects the circuit operation of IC 10. However, if substrate 50 is not grounded, as can happen while IC 10 is inserted or removed from a hot socket, i.e., a socket to which $V_{CC}$ and the input signal are supplied, transistor 46 is no longer guaranteed to be in an off state.

If, for example, $V_{IN}$ applied to input 14 is greater than $V_{CC}$, which can be the case, it is believed that a failure mode is created by transistor 26 (or other signal path) being rendered conductive to supply current into substrate 50. With the potential of substrate 50 floating, a current path is provided through the substrate to turn on transistor 46 of SCR 12 through P+ region 62: gate electrode "G". This produces a regenerative action as transistor 48 is thereby rendered conductive. SCR 12 is quickly latched on to generate a large current spike which can destroy the IC.

Turning to FIG. 3 there is shown IC 10 in cross-sectional view illustrating the Schottky diode protection clamp circuit of the preferred embodiment which inhibits SCR 12 from being rendered conductive as aforedescribed. It is to be understood that the same reference numerals used in FIG. 2 are utilized in FIG. 3 to identify corresponding elements. Additional P+ region 84 is formed in epitaxial region 64 to which metal deposition layer 74 is contacted. Similarly, additional P+ region 86 is formed in tub 66 to which metal layer 80 is contacted. Thus, a pair of Schottky diodes are formed across the base-emitter junctions of parasitic transistors 46 and 48 as illustrated in FIG. 4. Schottky diodes 88 and 90 clamp the base-emitter junctions of transistors 48 and 46 respectively. These diodes restrict either transistor or parasitic SCR 12 from entering the active region of operation. Therefore, the current spike that can otherwise be generated in IC 10 of FIGs. 1 and 2 is inhibited by the Schottky diode clamp protection circuit. This is due to the fact that diode 88 serves to clamp the epi voltage of tub 64 to a value:

$$V_N - \Psi \quad \text{(for positive } V_N\text{)}$$

where $V_N$ is the input voltage present at pin 14 and is the forward voltage drop of a Schottky diode. This will be transparant during normal circuit operation, and will prevent active operation of transistor 48 when IC 10 is inadvertently operated with substrate 50 not grounded as previously described. Diode 90 is reverse biased during normal operation, but will clamp the base-emitter junction of transistor 46 to $\Psi$ when the substrate is left floating.

Hence, what has been described above, is a novel Schottky diode clamp protection circuit which inhibits turn on of a parasitic SCR (comprised, in part, of a diffused resistor in a floating epitaxial island) in an IC due to the IC being operated with the substrate ungrounded.

CLAIMS

1. In a monolithic integrated circuit formed by a substrate (50) of a first semiconductor material of a first conductivity type, an epitaxial layer (52) of a second semiconductor material of a second conductivity type, a plurality of regions (60, 62) of a semiconductor material of the first conductivity type formed in the circuit for isolating predetermined regions of the epitaxial layer from other of such epitaxial regions, and including at least one transistor (26) formed in a first one of the isolated epitaxial regions and a resistor (40) formed in a second one (64) of the isolated regions, conducting means (74) for connecting the resistor between a first terminal at which is intended to be supplied an input signal and a first circuit node, and means for supplying an operating potential to the circuit, a protection circuit for inhibiting current transients that can otherwise occur when the substrate is not maintained at a fixed reference potential when the input signal and the operating potential are simultaneously applied to the circuit, comprising:
        a first Schottky diode (88) formed in the second one of the isolated epitaxial regions; and
        a second Schottky diode (90) formed in a third one of the isolated epitaxial region such that said first and second Schottky diodes inhibit turn on of any parasitic device that may be formed between the resistor and said third isolated epitaxial region through the substrate to inhibit the current transients.

2. In a monolithic integrated line receiver circuit (10) including a floating resistor (40) formed in a first epitaxial region (64) thereof, a second epitaxial region (66) which is isolated from the first epitaxial region, means for connecting (74, 78) one end of the resistor to a first external terminal and connecting the second epitaxial region to a second external terminal at which are supplied an input signal ($V_1$) and an operating potential ($V_{CC}$) respectively, an amplifier stage (26) formed in a third epitaxial region which is isolated from both the first and second epitaxial regions, the amplifier stage being connected to the other end of the resistor, a protection circuit for inhibiting current transients that otherwise may occur if the substrate of the line receiver circuit is not grounded when both the input signal and the operating potential are simultaneously applied thereto due to a parasitic device (12) being rendered conductive, the parasitic device being formed between the resistor, the first epitaxial region, and the second epitaxial region through the substrate, comprising:

a first Schottky diode (88) formed in the first epitaxial region; and

a second Schottky diode (90) formed in the second epitaxial region, said first and second Schottky diodes inhibiting turn on of the parasitic device.

3. A monolithic integrated circuit including a substrate (50) of a first conductivity semiconductor material, an epitaxial layer (52) of a second conductivity semiconductor material disposed on the substrate, a plurality of isolating regions (60, 62) of said first conductivity semiconductor material formed through the epitaxial layer in contact with the substrate which produce a plurality of separate isolated epitaxial regions (64, 66) in the epitaxial layer, a resistor (40) formed in a first one of the isolated epitaxial regions, electrical conductivity means (74, 78) for both connecting one end of the resistor and a second one of the isolated epitaxial regions to first and second terminals respectively, the first and second terminals being adapted to receive respectively an input voltage signal and an operating potential, the improvement comprising a protection circuit including:

first Schottky diode means (88) formed in the first isolated epitaxial region; and

second Schottky diode means (90) formed in the second isolated epitaxial layer region, said first and second Schottky diode means forming a clamp circuit for inhibiting turn on of a parasitic silicon controlled rectifier that can otherwise be turned on if the substrate of the monolithic integrated circuit is not at ground reference potential when the input voltage signal and the operating potential are applied to the monolithic integrated circuit.

FIG. 1

FIG. 2

0149065

FIG. 3

FIG. 4